(19)

**Europäisches Patentamt**
**European Patent Office**
**Office européen des brevets**

(11)　　**EP 2 165 158 B1**

(12)　　　　　**EUROPÄISCHE PATENTSCHRIFT**

(45) Veröffentlichungstag und Bekanntmachung des Hinweises auf die Patenterteilung:
**02.03.2011   Patentblatt 2011/09**

(21) Anmeldenummer: **08761158.8**

(22) Anmeldetag: **18.06.2008**

(51) Int Cl.:
*G01D 5/14* (2006.01)　　　*G06F 3/038* (2006.01)

(86) Internationale Anmeldenummer:
**PCT/EP2008/057704**

(87) Internationale Veröffentlichungsnummer:
**WO 2009/007210 (15.01.2009 Gazette 2009/03)**

(54) **MESSVERFAHREN, SENSORANORDNUNG UND MESSSYSTEM**

MEASUREMENT METHOD, SENSOR ARRANGEMENT AND MEASUREMENT SYSTEM

PROCÉDÉ DE MESURE, ARRANGEMENT DE DÉTECTION ET SYSTÈME DE MESURE

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **06.07.2007   DE 102007031511**
**06.08.2007   DE 102007036984**

(43) Veröffentlichungstag der Anmeldung:
**24.03.2010   Patentblatt 2010/12**

(73) Patentinhaber: **Austriamicrosystems AG**
**8141 Unterpremstätten (AT)**

(72) Erfinder:
　• **ZANGL, Hubert**
　　**A-8051 Graz (AT)**

　• **BRETTERKLIEBER, Thomas**
　　**A-8501 Lieboch (AT)**
　• **STEINER, Gerald**
　　**A-8010 Graz (AT)**
　• **BRANDNER, Markus**
　　**A-8052 Graz (AT)**

(74) Vertreter: **Epping - Hermann - Fischer**
**Patentanwaltsgesellschaft mbH**
**Ridlerstrasse 55**
**80339 München (DE)**

(56) Entgegenhaltungen:
**EP-A- 0 621 493**　　　**WO-A-00/23824**
**WO-A-2008/031725**　　**US-A- 5 959 863**
**US-A1- 2002 077 752**

**Beschreibung**

Die Erfindung betrifft ein Messverfahren, eine Sensoranordnung zur Verwendung mit einer sektorenförmig magnetisierten Magnetquelle sowie ein Messsystem mit der Sensoranordnung.

Sensoranordnungen, welche Magnetfeldsensoren zur Messung einer magnetischen Feldintensität umfassen, können benutzt werden, um eine winkelmäßige Abweichung einer Magnetquelle in Bezug auf die Position oder Ausrichtung der Magnetfeldsensoren zu bestimmen. Als Magnetquellen werden dabei vielfach diametral magnetisierte und drehbar gelagerte Magnetquellen verwendet.

Die Magnetfeldsensoren können dabei beispielsweise entlang eines kreisförmigen Umfangs angeordnet sein und über diesen Umfang Sensorsignale bereitstellen, die ungefähr eine sinusförmige Kurve bilden, abhängig von der Position und der Ausrichtung der Magnetquelle. Bei einem diametral magnetisierten Magneten lassen sich beispielsweise Sensorsignale von Magnetfeldsensoren auswerten, die in Bezug auf den kreisförmigen Umfang ungefähr in einem rechten Winkel angeordnet sind. Auf diese Weise lässt sich anhand der gemessenen Sensorsignale ein Drehwinkel der Magnetquelle in Bezug auf die Anordnung der Magnetfeldsensoren bestimmen.

Neben einer Rotation um die Achse, welche senkrecht auf der durch den kreisförmigen Umfang gebildeten Fläche steht, kann die Magnetquelle bezüglich ihrer Bewegung weitere Freiheitsgrade aufweisen. Beispielsweise kann die Magnetquelle um weitere Achsen verkippt werden beziehungsweise entlang von Raumachsen verschoben werden. Die Magnetquelle kann also in Abhängigkeit dieser Freiheitsgrade verschiedene Positionen einnehmen.

Im Bereich herkömmlicher Lösungen zur Positionsbestimmung zeigt die EP 0621493 A1 ein System zur Positions- und Orientierungsbestimmung von Seefahrzeugen im Meer. Hierbei ist eine Vielzahl von Magnetfeldsensoren vorgesehen, die durch die magnetischen Eigenschaften des Seefahrzeugs, z. B. eines U-Boots, beeinflusst werden. Die gemessenen Werte werden mit zuvor berechneten Referenzwerten verglichen, um die Positionsbestimmung durchzuführen. Die Magnetfeldsensoren sind beispielsweise in beliebiger Form am Meeresgrund angeordnet.

Das Dokument WO 00/23824 beschreibt ein mathematisches Verfahren, mit dem durch Magnetfeldquellen erzeugte Signale ausgewertet werden können, um eine Position der Magnetfeldquelle zu bestimmen. Anwendungsgebiet ist hierfür beispielsweise die Verfolgung von Seefahrzeugen oder alternativ Landfahrzeugen.

Das Dokument US 5,959,863 zeigt eine Anordnung, bei der der Hebel eines Joysticks in mehreren Richtungen bewegbar bzw. um mehrere Achsen drehbar ist. Beispielsweise sind zur Positionsdetektion mehrere Hallsensoren und eine kreuzförmige Taumelscheibe, an deren Enden jeweils Permanentmagnete eingelassen sind, vorgesehen. Durch Auswertung der Signale der Hall-sensoren wird die Position bestimmt, welche sowohl translatorische als auch rotatorische Komponenten aufweist.

Das Dokument US 2002/077752 beschreibt eine Anordnung zur magnetbasierten Positionsbestimmung, bei der mehrere Hallsensoren jeweils eine von einer Magnetquelle erzeugte Magnetfeldintensität aufnehmen. Die gemessenen Werte werden mit Referenzwerten verglichen, um die relative Position zwischen Magnetquelle und Sensoren zu bestimmen.

Es ist eine Aufgabe der Erfindung, ein Verfahren zur Bestimmung einer Position einer Magnetquelle anzugeben, das mit geringem Aufwand realisierbar ist. Es ist auch eine Aufgabe der Erfindung, eine Anordnung bereit zu stellen, die geeignet ist, mit geringem Aufwand die Position einer Magnetquelle zu bestimmen.

Diese Aufgabe wird mit den Gegenständen der unabhängigen Patentansprüche gelöst. Ausgestaltungsformen und Weiterbildungen der Erfindung sind Gegenstand der Unteransprüche.

In einem Ausführungsbeispiel eines Messverfahrens wird ein Array von Magnetfeldsensoren bereitgestellt, die jeweils ein Sensorsignal in Abhängigkeit einer magnetischen Feldintensität abgeben. Ferner wird eine sektorenförmig magnetisierte Magnetquelle bereitgestellt, die beweglich zu dem Array angeordnet ist. In Abhängigkeit der abgegebenen Sensorsignale wird ein Rotationswert der Magnetquelle gegenüber dem Array von Magnetfeldsensoren ermittelt. Zudem wird aus den Sensorsignalen ein Satz von Sensorwerten abgeleitet. In Abhängigkeit des ermittelten Rotationswerts wird eine Anzahl von Sätzen von Referenzwerten ermittelt, die einer Anzahl vorbestimmter Positionen der Magnetquelle entspricht. Es wird eine Vergleichsoperation zwischen dem Satz von Sensorwerten und der Anzahl von Sätzen von Referenzwerten durchgeführt und eine Position aus der Anzahl vorbestimmter Positionen in Abhängigkeit der Vergleichsoperation ausgewählt.

Die Magnetquelle kann dabei eine diametral magnetisierte Magnetquelle sein, die dementsprechend jeweils einen Nord- und einen Südpol aufweist.

Die im Array vorgesehene Anzahl von Magnetfeldsensoren gibt eine entsprechende Anzahl von Sensorsignalen ab, die je nach Ausführungsform eine analoge oder digitale Signalform aufweisen. Beim Ableiten des Satzes von Sensorwerten werden aus den zur Verfügung stehenden Sensorsignalen Sensorwerte in einer bestimmten Anzahl ermittelt, die gleich groß oder kleiner sein kann als die Anzahl der Sensorsignale. Diese Anzahl von Sensorwerten bildet dann einen Satz, der für die weitere Verarbeitung genutzt wird. Beim Ableiten können unter anderem einzelne Sensorsignale zu einem Sensorwert zusammengefasst werden, wobei dies durch Summen- oder Differenzbildung erfolgen kann. Das Ableiten der Sensorwerte kann auch eine Analog-Digitalwandlung der Sensorsignale umfassen. Ferner kann das Ableiten der Sensorwerte auch umfassen, dass bestimmte Sensorsignale jeweils bestimmten Sensorwerten zugeordnet werden können. Vorzugsweise entsprechen sich die Anzahl von Sensorwerten in dem Satz von Sensorwerten und eine jeweilige Anzahl von Referenzwerten in den Sätzen von Referenzwerten, während die Anzahl der Sensorsignale von der genannten Anzahl abweichen kann.

Die Position der Magnetquelle, welche durch das Verfahren bestimmt werden kann, ergibt sich aus Bewegungen der Magnetquelle innerhalb mehrerer Freiheitsgrade. So kann die Magnetquelle beispielsweise um jede von drei Raumachsen im dreidimensionalen Raum gedreht beziehungsweise gekippt werden. Ferner kann die Magnetquelle auch entlang jeder der drei Raumachsen verschoben werden. Sowohl bei der Verkippung beziehungsweise Verdrehung als auch bei der Verschiebung der Magnetquelle kann von einer ursprünglichen Ausgangsposition oder Referenzposition ausgegangen werden. Die Position der Magnetquelle kann also mehrere Verkippungskomponenten aufweisen, wie zum Beispiel den Rotationswert um eine senkrecht zu der Anordnung von Magnetfeldsensoren stehenden Drehachse, welche als z-Achse bezeichnet werden kann, oder die Verkippung um eine x-Achse oder eine y-Achse, die mit der z-Achse ein rechtwinkeliges Koordinatensystem bilden. Die Verkippungskomponenten können dabei sowohl positive als auch negative Werte annehmen.

Die Position der Magnetquelle kann auch durch Verschiebungskomponenten entlang der x-Achse beziehungsweise der y-Achse sowohl in positiver als auch in negativer Richtung ausgedrückt werden. Ferner kann auch eine Verschiebung entlang der z-Achse eine Verschiebungskomponente darstellen, welche beispielsweise eine Druckfunktion oder Zugfunktion der Magnetquelle in Richtung der Rotationsachse der Magnetquelle entspricht.

Unter einer der vorbestimmten Positionen der Magnetquelle können in verschiedenen Ausführungsformen auch jeweilige Positionsbereiche verstanden werden, welche mehrere diskrete Positionen umfassen. Beispielsweise ergibt sich die Anzahl der vorbestimmten Positionen aus einer jeweiligen Zusammenfassung verschiedener möglicher Positionen der Magnetquelle innerhalb der jeweiligen Freiheitsgrade.

Für jede der Positionen beziehungsweise der Positionsbereiche können Referenzwerte bestimmt werden. Die Bestimmung kann beispielsweise durch eine Messung über einen Referenzsensor oder eine Referenzsensoranordnung für die vorbestimmten oder möglichen Positionen erfolgen. Alternativ können die Referenzwerte auch durch eine Berechnung oder Simulation des magnetischen Felds der Magnetquelle abgeleitet werden. Hierzu lässt sich beispielsweise ein Finite-Elemente-Modell verwenden. Aus den so gewonnenen Referenzwerten können die Sätze von Referenzwerten gebildet werden, welche jeweils einer der vorbestimmten Positionen der Magnetquelle entsprechen.

Um aus den Sensorsignalen beziehungsweise dem daraus abgeleiteten Satz von Sensorwerten die Position der Magnetquelle zu bestimmen, kann eine Schätzung oder Detektion durchgeführt werden, mit welchem Satz von Referenzwerten die Sensorwerte, also der Satz von Sensorwerten, am besten übereinstimmen. Anders ausgedrückt kann durch die Schätzung oder Detektion ermittelt werden, welcher der vorbestimmten Positionen die Sensorwerte am ehesten entsprechen. Dabei wird für jeden der Sätze von Referenzwerten eine Wahrscheinlichkeit ermittelt, mit der eine Übereinstimmung der Sensorwerte des Satzes mit den Referenzwerten zutrifft. Anders ausgedrückt kann ein Vertrauenswert für jeden der Sätze von Referenzwerten beziehungsweise für jede der vorbestimmten Positionen ermittelt werden, der ein Maß für die Wahrscheinlichkeit angibt, dass die Magnetquelle die jeweilige Position eingenommen hat.

Als Position der Magnetquelle kann demzufolge derjenige Satz von Referenzwerten beziehungsweise diejenige Position aus den vorbestimmten Positionen ausgewählt werden, welche das beste Schätzergebnis oder Detektionsergebnis aufweist. Die Position kann demnach in Abhängigkeit eines Extremwerts, beispielsweise eines Minimalwerts oder eines Maximalwerts der ermittelten Vertrauenswerte beziehungsweise der ermittelten Wahrscheinlichkeiten ausgewählt werden. Die Ermittlung der Position kann zum Beispiel über Verfahren erfolgen, welche das Prinzip der Detektion des nächsten Nachbars, englisch nearest neighbor detection (NND) oder der Maximum a posteriori Detektion (MAP) anwenden.

Um den Aufwand des Verfahrens zusätzlich verringern zu können, können in weiteren Ausführungsformen die Referenzwerte approximiert werden. Beispielsweise lassen sich die messtechnisch oder mittels Feldberechnung ermittelten Werte über Näherungsfunktionen darstellen. Die Referenzwerte können zum Beispiel durch eine polynomielle Approximation und/oder durch eine Taylor-Reihenentwicklung angenähert werden. Durch derartige Näherungen kann der Aufwand bei der Bestimmung der Position weiter reduziert werden, während die Genauigkeit des Verfahrens im Wesentlichen unverändert ist.

In einem Ausführungsbeispiel einer Sensoranordnung umfasst diese ein Array von Magnetfeldsensoren, die jeweils eingerichtet sind, ein Sensorsignal in Abhängigkeit einer magnetischen Feldintensität abzugeben. Ferner ist eine mit dem Array von Magnetfeldsensoren gekoppelte Auswerteeinrichtung vorgesehen, die dazu eingerichtet ist, die Bestimmung eines Rotationswerts, das Ermitteln von Sätzen von Referenzwerten in Abhängigkeit des Rotationswerts und das Durchführen einer Vergleichsoperation in Abhängigkeit der Referenzwerte und der Sensorsignale sowie das Auswählen einer Position in Abhängigkeit der Vergleichsoperation durchzuführen gemäß einem der oben beschriebenen Ausführungsbeispiele.

Die Magnetfeldsensoren können dabei beispielsweise Hall-Sensoren umfassen. Die Auswerteeinrichtung, welche die von den Magnetfeldsensoren abgegebenen Sensorsignale verarbeitet, weist beispielsweise einen oder mehrere Analog-Digital-Wandler, eine Speichereinrichtung, einen digitalen Signalprozessor und/oder einen Microcontroller auf. Das Verarbeiten der Sensorsignale kann also beispielsweise in dem Signalprozessor und/oder dem Microcontroller erfolgen. Alternativ oder zusätzlich kann das Verarbeiten der Sensorsignale auch in einem Field Programmable Gate Array, FPGA oder in anderer dedizierter Hardware erfolgen. Somit kann die Position einer Magnetquelle, welche mit der Sensoranordnung verwendet werden kann, mit geringem Aufwand und genau bestimmt werden.

In einem Ausführungsbeispiel eines Messsystems umfasst dieses eine Sensoranordnung gemäß einem der beschriebenen Ausführungsbeispiele sowie eine sektorenförmig magnetisierte Magnetquelle, die beweglich zu dem Array der Sensoranordnung angeordnet ist.

In einer Ausführungsform des Messsystems ist die Magnetquelle mit einem Hebel mechanisch gekoppelt. Beispielsweise dient der Hebel als Eingabegerät oder Steuergerät. Das Messsystem kann zum Beispiel von einem Joystick umfasst sein, welcher an ein System zur elektronischen Datenverarbeitung anschließbar ist.

Im Folgenden wird die Erfindung an mehreren Ausführungsbeispielen anhand der Figuren näher erläutert. Funktions- beziehungsweise wirkungsgleiche Elemente tragen dabei gleiche Bezugszeichen.

Es zeigen:

Figur 1        ein erstes Ausführungsbeispiel einer Sensoranord- nung,

Figur 2        eine schematische Darstellung eines Ausführungsbei- spiels von Magnetfeldsensoren mit einer Magnetquel- le,

Figur 3        ein erstes beispielhaftes Diagramm von magnetischen Feldintensitäten,

Figur 4        ein zweites beispielhaftes Diagramm von magneti- schen Feldintensitäten,

Figur 5        ein erstes beispielhaftes Diagramm mit Vektoren von Zwischensignalen zur Berechnung eines Rotationswer- tes,

Figur 6        ein zweites beispielhaftes Diagramm mit Vektoren von Zwischensignalen zur Berechnung eines Rotati- onswertes,

Figur 7        ein beispielhaftes Diagramm mit Sektoren von Mag- netfeldintensitäten,

Figur 8        ein beispielhaftes Diagramm von Referenzwerten von Magnetfeldintensitäten,

Figur 9        ein beispielhaftes Diagramm mit Positionsbereichen,

Figur 10       ein zweites Ausführungsbeispiel einer Sensoranord- nung und

Figur 11       ein beispielhaftes Ablaufdiagramm eines Messverfah- rens.

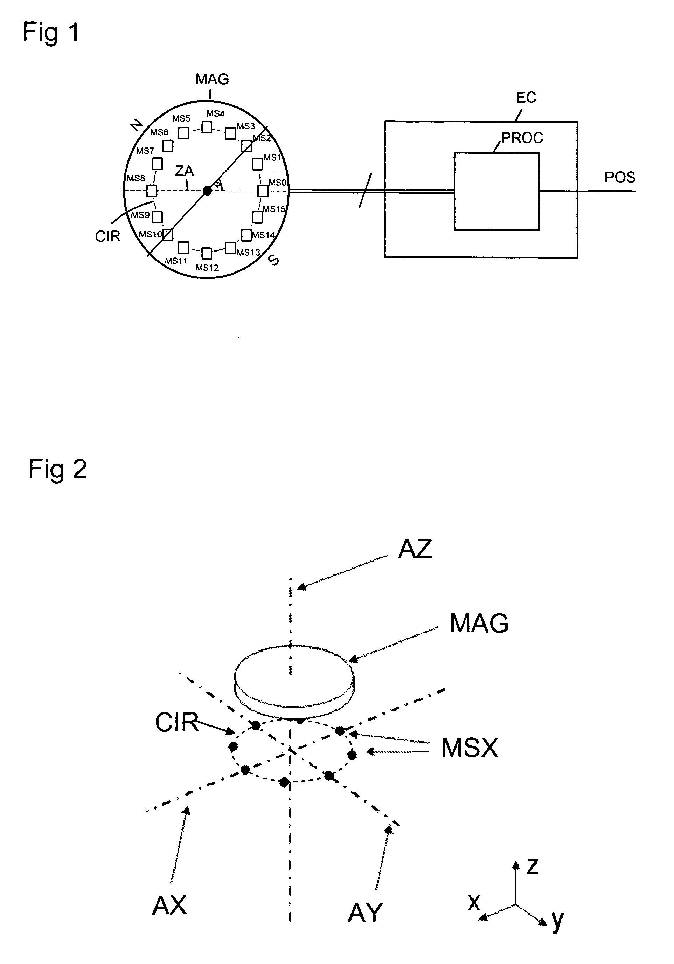

Figur 1 zeigt ein Ausführungsbeispiel einer Sensoranordnung, die ein Array von Magnetfeldsensoren MS0 - MS15 umfasst, welche gleichmäßig entlang eines kreisförmigen Umfangs CIR angeordnet sind. Die Magnetfeldsensoren MS0 bis MS15 sind mit einer Auswerteeinrichtung EC gekoppelt, welche eine Recheneinheit PROC, beispielsweise einen Microcontroller aufweist. Die Magnetfeldsensoren MS0 bis MS15 sind jeweils dazu eingerichtet, ein Sensorsignal in Abhängigkeit einer magnetischen Feldintensität abzugeben. Das Sensorsignal kann dabei beispielsweise als analoges Spannungs- oder Stromsignal abgegeben werden, welches zur weiteren Verarbeitung über einen hier nicht dargestellten Analog-Digital-Wandler in einen digitalen Wert umgesetzt werden kann. Ein derartiger Analog-Digital-Wandler kann beispielsweise direkt bei den Magnetfeldsensoren MS0 bis MS15 vorgesehen sein oder alternativ von der Auswerteeinrichtung EC umfasst sein.

Die in Figur 1 dargestellte Sensoranordnung kann mit einer sektorenförmig magnetisierten Magnetquelle MAG verwendet werden, welche in diesem Ausführungsbeispiel als diametral magnetisierte Magnetquelle mit jeweils einem Nordpol und einem Südpol ausgeführt ist. In anderen Ausführungsbeispielen können auch Magnetquellen mit mehreren Sektoren verwendet werden, so dass die Magnetquelle jeweils mehr als einen Nordpol und mehr als einen Südpol aufweist. Anders ausgedrückt kann eine Magnetquelle mit einer beliebigen Polpaarzahl verwendet werden.

In der Auswerteeinrichtung EC können die Sensorsignale der Magnetfeldsensoren MS0 - MS15, welche beispielsweise als Hall-Sensoren ausgeführt sind, ausgewertet werden, um zunächst einen Rotationswert $\varphi$ der Magnet- quelle MAG in Bezug auf eine Referenzachse ZA des Arrays von Magnetfeldsensoren MS0 bis MS15 zu ermitteln. In Abhängigkeit des ermittelten Rotationswertes $\varphi$ werden in der Auswerteeinrichtung EC eine Anzahl von Sätzen von Referenzwerten ermittelt, welche einer Position der Magnetquelle MAG im dreidimensionalen Raum zuordenbar sind. Ferner kann aus den Sensorsignalen ein Satz von Sensorwerten abgeleitet werden, der in einer Vergleichsoperation mit den ermittelten Sätzen von Referenzwerten verglichen wird. Aus dem Vergleichsergebnis lässt sich ein Satz von Referenzwerten auswählen, welcher eine angenommene Position POS der Magnetquelle MAG darstellt.

Figur 2 zeigt eine schematische Darstellung des Arrays von Magnetfeldsensoren, das in diesem Ausführungsbeispiel acht Magnetfeldsensoren MSX umfasst, die entlang des kreisförmigen Umfangs CIR angeordnet sind. Ferner ist eine Magnetquelle MAG dargestellt, welche beweglich zu dem Array angeordnet ist. Zusätzlich sind eine x-Achse AX, eine y-Achse AY und eine z-Achse AZ als Raumachsen eines dreidimensionalen Koordinatensystems x, y, z dargestellt. Der kreisförmige Umfang CIR liegt dabei beispielsweise in einer von den Achsen AX und AY aufgespannten Fläche beziehungsweise einer Fläche, welche im Wesentlichen parallel zu der genannten Fläche angeordnet ist. Die Magnetquelle MAG ist beispielsweise drehbar um die z-Achse AZ gelagert, so dass eine Position der Magnetquelle von einem Drehwinkel um die z-Achse AZ abhängt. Des Weiteren kann die Magnetquelle MAG auch um die x-Achse AX und/oder die y-Achse AY verkippt werden, so dass die Position der Magnetquelle MAG auch von der jeweiligen Verkippung abhängt. Neben der Rotation und der Verkippung kann eine Position der Magnetquelle MAG auch von einer Verschiebung entlang einer der Achsen AX, AY, AZ abhängen. Somit ergeben sich in diesem Ausführungsbeispiel aus der Rotationsmöglichkeit, den zwei Verkippungsmöglichkeiten und den drei Verschiebungsmöglichkeiten insgesamt sechs Freiheitsgrade für die Beschreibung einer Position der Magnetquelle MAG.

In Abhängigkeit der jeweiligen Position der Magnetquelle MAG können an den jeweiligen Magnetfeldsensoren MSX jeweilige Magnetfeldintensitäten erzeugt werden, welche sich von den Magnetfeldsensoren MSX in entsprechende Sensorsignale umwandeln lassen.

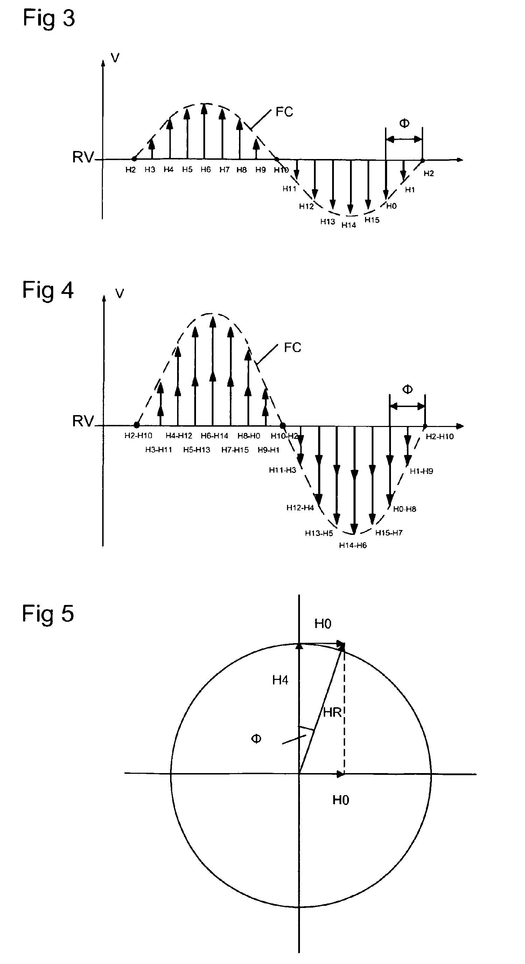

Figur 3 zeigt ein beispielhaftes Diagramm mit einem sinusförmigen Verlauf FC von Magnetfeldintensitäten, der durch Sensorsignale beziehungsweise Sensorwerte H0 - H15 gebildet ist. Die Sensorsignale beziehungsweise Sensorwerte H0 bis H15 werden beispielsweise von einem Sensorarray mit Magnetfeldsensoren MS0 - MS15 gemäß dem in Figur 1 dargestellten Ausführungsbeispiel abgegeben. Die Sensorsignale sind in diesem Ausführungsbeispiel als Spannungssignale V dargestellt, wobei sich für den sinusförmigen Verlauf FC ein Mittelwert RV ergibt, welcher in der Regel unabhängig von einer Feldintensität ist, die von einer Magnetquelle abgegeben wird. Unter der Annahme, dass eine Referenzachse ZA wie im Ausführungsbeispiel von Figur 1 festgelegt ist, ergibt sich ein Rotationswert Φ, welcher sich aus dem sinusförmigen Verlauf FC ermitteln lässt. Aus den Sensorwerten lässt sich ein Satz von Sensorwerten bilden, der für die oben beschriebene Vergleichsoperation mit dem Satz von Referenzwerten verwendet werden kann.

Figur 4 zeigt ein weiteres beispielhaftes Diagramm eines sinusförmigen Verlaufs FC, welcher aus Sensorsignalen beziehungsweise Sensorwerten H0 bis H15 entsprechender Magnetfeldsensoren MS0 bis MS15 resultiert. Dabei sind Sensorsignale von gegenüber liegenden beziehungsweise räumlich um 180 Grad verschobenen Magnetfeldsensoren miteinander kombiniert beziehungsweise voneinander abgezogen. Die aus der Kombination beziehungsweise Subtraktion resultierenden Sensorwerte sind dadurch unempfindlicher gegen magnetische Störfelder, welche im Wesentlichen gleichmäßig auf alle der Magnetfeldsensoren einwirken.

Aus den in Figur 3 und Figur 4 dargestellten Sensorsignalen beziehungsweise Sensorwerten kann mit verschiedenen Methoden ein Rotationswert der Magnetquelle MAG bestimmt werden. Beispielsweise kann über eine Fourier-Analyse beziehungsweise Fourier-Transformation der Sensorsignale der entsprechende Rotationswert abgeleitet werden. Alternativ lässt sich der Rotationswert auch über Winkelfunktionen in Abhängigkeit der Sensorsignale beziehungsweise Sensorwerte bestimmen.

Figur 5 zeigt ein Vektordiagramm mit vektoriell dargestellten Sensorsignalen H0, H4, deren Vektorsumme einen resultierenden Vektor einer Magnetfeldintensität HR ergibt. Die Sensorwerte H0, H4 werden dabei von zueinander senkrecht angeordneten Magnetfeldsensoren MS0, MS4, entsprechend dem in Figur 1 dargestellten Ausführungsbeispiel abgegeben. Der Rotationswert ergibt sich gemäß dem in Figur 5 dargestellten Diagramm beispielsweise als

$$\Phi = \arctan \frac{H_0}{H_4} . \qquad\qquad (1)$$

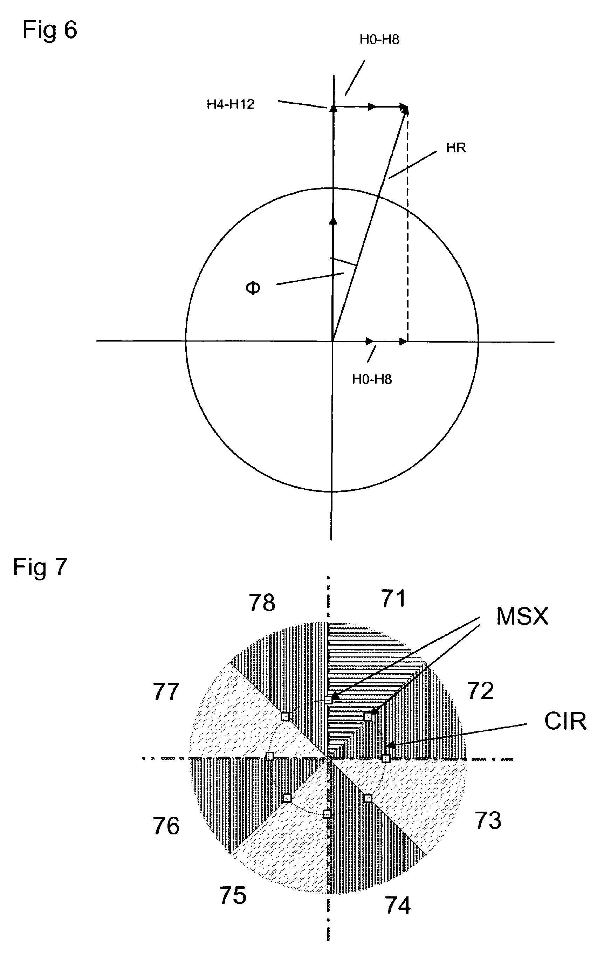

Figur 6 zeigt ein weiteres beispielhaftes Vektordiagramm, bei dem Sensorsignale beziehungsweise Sensorwerte entsprechend dem in Figur 4 dargestellten Diagramm miteinander kombiniert sind. Der resultierende Vektor HR der Magnetfeldintensität ergibt sich aus der Summe der zueinander orthogonalen Anteile H4-H12 und H0-H8. Der Rotationswert Φ kann demnach beispielsweise über

$$\Phi = \arctan \frac{H_2 - H_0}{H_4 - H_{12}} \qquad\qquad (2)$$

ermittelt werden.

Neben den beschriebenen Verfahren können auch weitere Verfahren zur Bestimmung des Rotationswerts $\Phi$ eingesetzt werden.

Verschiedene Positionen der Magnetquelle führen im Wesentlichen zu unterschiedlichen Feldverteilungen der magnetischen Feldintensität an den Magnetfeldsensoren. Diese können gemäß dem in Figur 1 dargestellten Ausführungsbeispiel ausgewertet werden, indem die Sensorwerte, die aus den von den Magnetfeldsensoren gemessenen Sensorsignalen abgeleitet sind, mit Referenzwerten verglichen werden. Das Array beziehungsweise die Anordnung von Magnetfeldsensoren weist wegen der gleichmäßigen Verteilung entlang des kreisförmigen Umfangs CIR Symmetrieeigenschaften auf. Deswegen sind die resultierenden Feldverteilungen aus verschiedenen Positionen bei entsprechender Verdrehung einander ähnlich, wenn die Verdrehung einem Winkelabstand zweier benachbarter Magnetfeldsensoren entspricht. Der Kreis beziehungsweise der kreisförmige Umfang CIR lässt sich dementsprechend in mehrere Sektoren einteilen, welche die Symmetrieeigenschaften bezüglich der Feldstärkeintensität beziehungsweise Feldverteilung berücksichtigen.

Figur 7 zeigt eine beispielhafte Einteilung des kreisförmigen Umfangs CIR, entlang dem acht Magnetfeldsensoren MSX angeordnet sind, in acht Sektoren 71 - 78. In dieser Anordnung würden die Magnetfeldsensoren MSX ähnliche Sensorsignale liefern, wenn beispielsweise ein Rotationswert der Magnetquelle von 10 Grad beziehungsweise 100 Grad vorliegen würde. Dabei könnten die jeweiligen Sätze von Sensorsignalen im Wesentlichen aus einer Umordnung der jeweiligen Sensorsignale der Magnetfeldsensoren und Vertauschung entsprechender Achsen betrachtet werden.

Dementsprechend lassen sich unter Annahme idealer Magnetfeldsensoren die Sektoren 73, 75 und 77 lediglich durch eine Neuordnung der Reihenfolge der Sensorsignale auf den Sektor 71 abbilden beziehungsweise lassen sich aus dem Sektor 71 ableiten. In ähnlicher Weise können zu erwartenden Sensorsignale in den Sektoren 72, 74, 76 und 78 durch Spiegelung der entsprechenden Sensorsignale aus dem Sektor 71 ableiten. Infolgedessen können beim Ableiten der Referenzwerte für den Vergleich mit den Sensorsignalen diese im wesentlichen für den ersten Sektor 71, das heißt für einen Rotationswert innerhalb dieses Sektors, abgeleitet werden, während sich die Referenzwerte für die übrigen Sektoren durch einfache Neuordnung, Vertauschung und/oder Spiegelung der Referenzwerte ermitteln lassen. Die Symmetrieeigenschaften können auch direkt beim Durchführen der Vergleichsoperation berücksichtigt werden. Anders ausgedrückt können beim Ermitteln von Sätzen von Referenzwerten und/oder beim Durchführen der Vergleichsoperation Symmetrieeigenschaften des Arrays von Magnetfeldsensoren genutzt werden.

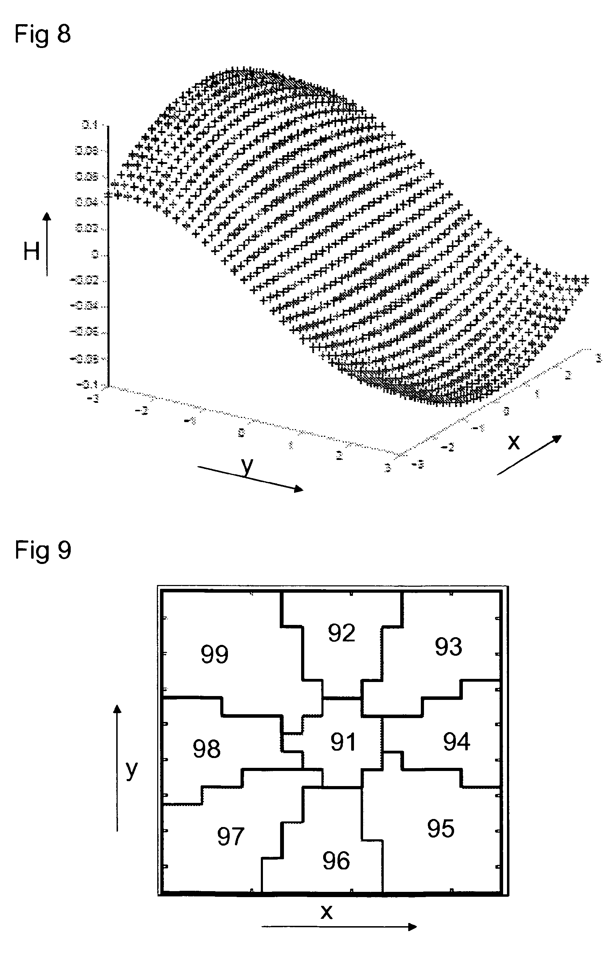

Figur 8 zeigt ein beispielhaftes Diagramm mit dem Verlauf einer magnetischen Feldintensität H im Bereich einer Magnetquelle gemäß einem der oben beschriebenen Ausführungsbeispiele für eine durch eine x-Achse und durch eine y-Achse bestimmte Fläche. Das Diagramm stellt den Verlauf der Magnetfeldintensität für eine mögliche Position der Magnetquelle dar. In dem Diagramm sind sowohl der Verlauf einer Feldverteilung, welcher mit einer Finite-Elemente-Methode berechnet ist, als auch eine Approximation des mittels Feld-Berechnung ermittelten Verlaufs dargestellt. Abweichungen ergeben sich im Wesentlichen lediglich in Randbereichen der Näherung.

Ein vergleichbarer Feldverlauf magnetischer Feldintensität könnte auch durch Messung mit einem Referenzsensor beziehungsweise einer Referenzsensoranordnung bestimmt werden.

Basierend auf dem ermittelten Rotationswert $\Phi$ können mehrere Sätze $S_k$ von Referenzwerten $s_{k,i}$ für eine Anzahl K vorbestimmter Positionen bestimmt werden, wobei jeder der Sätze $S_k$ eine Anzahl N von Referenzwerten umfasst, die einer Anzahl von Sensorwerten beziehungsweise ursprünglichen oder kombinierten Sensorsignalen entspricht, welche für die Vergleichsoperation herangezogen werden. Dementsprechend kann der Index i Werte von 1 bis N und der Index k Werte von 1 bis K annehmen.

Mit Verweis auf Figur 8 kann für die Herleitung der Referenzwerte ein Modell des Magnetfelds verwendet werden, welches zur Reduktion des Rechenaufwands auch über eine Approximation dargestellt werden kann. Dazu werden beispielsweise vergleichsweise einfache mathematische Funktionen verwendet, die derart parametriert werden, dass sie im betrachteten Bereich eine gute Näherung des tatsächlichen Feldverlaufs darstellen. Möglichkeiten dazu sind lineare oder polynomielle Approximationen, wie zum Beispiel eine Regression. Es können aber auch Funktionen höherer Ordnung zur Näherung von Magnetfeldern verwendet werden. Eine Bestimmung der Parameter der Näherung kann messtechnisch oder mit Hilfe einer Feldberechnung, beispielsweise einer Finite-Elemente-Simulation erfolgen. Für die Ermittlung eines Referenzwerts $s_{k,i}$ kann also eine Funktion $f_i$ aufgestellt werden, die abhängig vom Rotationswert $\Phi$ und einer der K vorbestimmten Positionen der Magnetquelle abhängt, so dass

$$s_{k,i} = f_i(\Phi, k) \quad \text{mit} \quad i = 1...N \quad \text{und} \quad k = 1...K \qquad (3)$$

Unter der Annahme, dass Y einen Satz von Sensorwerten $Y_i$ darstellt, die aus den von den Magnetfeldsensoren abgegebenen Sensorsignalen abgeleitet sind, können Kostenfunktionen $M_i(Y)$ mit

$$M_i(Y) = \sum_{i=0}^{N-1} \sum_{j=0}^{N-1} M_{i,j} P(H_i | H_j) P(H_j) \qquad (4)$$

aufgestellt werden, wobei $M_{i,j}$ für die Kosten einer Entscheidung steht, eine Hypothese $H_i$ zu wählen unter der Bedingung, dass die Hypothese $H_j$ wahr ist. Dabei steht P(H) für eine Wahrscheinlichkeit, dass die jeweilige Hypothese H zutrifft. Zur Auswahl der jeweiligen Position POS aus der Anzahl vorbestimmter Positionen unter Annahme gleicher Kosten $M_{i,j}$ für alle Positionen der Magnetquelle kann somit die Hypothese mit der höchsten Wahrscheinlichkeit unter Berücksichtigung der Sensorwerte Y bestimmt werden. Äquivalent dazu kann daher jene Hypothese $H_j$ gewählt werden, für die gilt:

$$p(Y|H_k) > p(Y|H_i) \forall i \neq k. \qquad (5)$$

Mit C als Kovarianzmatrix der gemessenen Sensorsignale ergibt sich diese Wahrscheinlichkeit unter Annahme einer Gaußverteilung der jeweiligen Unsicherheiten zu

$$p(Y|H_k) = \frac{1}{(2\pi)^{\frac{P}{2}}} \frac{1}{|C|^{\frac{1}{2}}} e^{-\frac{1}{2}(Y-S_k)^T C^{-1}(Y-S_k)}. \qquad (6)$$

Um den Rechenaufwand für die Berechnung der Referenzwerte beziehungsweise die Berechnung der jeweiligen Wahrscheinlichkeiten gering zu halten, können die üblicherweise nicht linearen Funktionen des magnetischen Feldmodells als stückweise konstante oder stückweise lineare Funktionen angenähert werden. Beispielsweise kann eine Näherung über einen bestimmten Winkelbereich konstant gehalten werden, so dass jeweils eines der Segmente der in Figur 7 dargestellten Aufteilung in kleinere Teilsegmente eingeteilt werden kann. Durch Logarithmieren und unter Berücksichtigung der Annahme, dass die Kovarianzmatrix C der Sensorwerte nur geringe Änderungen aufweist, kann an Stelle von Gleichung (6) auch die folgende, einfacher zu implementierende Gleichung verwendet werden:

$$\tilde{p}(Y|H_k) = -\frac{1}{2}(Y-S_k)^T C^{-1}(Y-S_k) \qquad (7)$$

Diese kann überführt werden in

$$\tilde{p}(Y|H_k) = \sum_{i=1}^{N} \sum_{j=1}^{N} C_{i,j} \cdot (Y_i - s_{k,i}) \cdot (Y_j - s_{k,j}), \qquad (8)$$

wobei $C_{i,j}$ jeweilige Einzelwerte der Kovarianzmatrix C repräsentiert. Bei Anwendung der Gleichung (8) wird also eine Vergleichsoperation durchgeführt, bei der Abweichungen zwischen den Sensorwerten $Y_i$ des Satzes Y von Sensorwerten und jeweils zugeordneten Referenzwerten $S_{k,i}$ der Sätze $S_k$ von Referenzwerten ermittelt werden. Somit werden für jede der möglichen vorbestimmten Positionen Wahrscheinlichkeiten oder Vertrauenswerte abgeleitet, wobei mit Verweis auf Gleichung (5) die Position mit dem höchsten Vertrauenswert beziehungsweise der höchsten Wahrscheinlichkeit ausgewählt wird.

Durch die verschachtelte Summenbildung in Gleichung (8) kommt es beim Ableiten der Wahrscheinlichkeiten beziehungsweise der Vertrauenswerte zu einer quadratischen Aufsummierung der Abweichungen, die dem entsprechend für alle der vorbestimmten Positionen durchgeführt wird. Das Bestimmen der Hypothese mit der höchsten Wahrscheinlichkeit kann auch als ein Maximum Likelihood-Verfahren bezeichnet werden. Wenn dazu, wie zur Gleichung (7) ausgeführt, eine Logarithmierung der entsprechenden Wahrscheinlichkeitsfunktionen vorgenommen wird, kann auch von einem logarithmierten Likelihood-Verfahren gesprochen werden. Derartige Likelihood-Verfahren können auch unter dem Begriff Schätzverfahren oder Wahrscheinlichkeitsverfahren zusammengefasst werden.

Bei der Bestimmung der Abweichungen zwischen den Sensorwerten $Y_i$ und den Referenzwerten $S_{k,i}$ können einzelne Abweichungswerte unterschiedliche Bedeutung haben, die unter anderem von Art und Richtung einer Verkippung abhängig sein kann. Wenn beispielsweise eine Verkippung entlang einer Achse erfolgt, die durch zwei gegenüber liegende Magnetfeldsensoren gebildet wird, kann erwartet werden, dass die von diesen Magnetfeldsensoren abgegebenen Sensorsignale keinen wesentlichen Einfluss auf ein Ergebnis einer Positionsbestimmung haben beziehungsweise haben sollten. Wenn jedoch diese Magnetfeldsensoren betragsmäßig große Sensorsignale liefern, beispielsweise in Abhängigkeit eines bestimmten Rotationswerts der Magnetquelle, können entsprechende Abweichungen aus diesen Sensorsignalen theoretisch einen größeren Einfluss haben als aus Geometriegründen erforderlich.

Aus diesem Grund können Gewichtsfaktoren eingeführt werden, welche beispielsweise derartige Abweichungen mit einem geringeren Gewichtsfaktor belegen und Abweichungen, die aus betragsmäßig kleineren Sensorsignalen resultieren, aber aus geometrischer Betrachtung einen höheren Stellenwert haben, mit höheren Gewichtsfaktoren. Derartige Gewichtsfaktoren können zum Beispiel in Gleichung (8) mit in die Kovarianzmatrix $C_{i,j}$ integriert werden. Die Größe beziehungsweise der Betrag der jeweiligen Gewichtsfaktoren kann ähnlich wie die Referenzwerte, messtechnisch und/ oder mittels Feldberechnung hergeleitet werden. Die jeweils verwendeten Gewichtsfaktoren können dabei wiederum von dem ermittelten Rotationswert abhängen.

Die Gewichte für die einzelnen Sensorwerte können nach verschiedenen Verfahren ermittelt werden, wobei die Toleranzen, gegenüber denen eine Sensoranordnung mit dem beschriebenen Messverfahren unempfindlich sein soll, eine wesentliche Rolle einnehmen. Für einen theoretischen idealen Sensor ohne mechanische, magnetische oder elektronische Toleranzen sowie ohne Rauschen können alle Gewichte auf denselben Wert gesetzt werden. Da dieser Fall in der Praxis jedoch nicht realisierbar ist, kann eine geeignete Wahl der Gewichte für eine verbesserte Funktion erstrebenswert sein. Eine Möglichkeit zur Bestimmung der Gewichte ist ein Maximum-Likelihood Verfahren, bei dem die Gewichte aus den Kovarianzmatrizen der Messwerte für die jeweilige Position bei gegebener Rotation berechnet werden. Eine messtechnische Bestimmung und Abspeicherung in Tabellen kann ebenfalls durchgeführt werden, weist aber aufgrund der Vielzahl von Einflussfaktoren einen höheren Aufwand auf. Demgemäß kann die Bestimmung der Kovarianzmatrizen analog zur Bestimmung der erwarteten Messwerte mit Hilfe von Näherungsformeln für das Magnetfeld erfolgen.

In einer weiteren Näherung zur Reduzierung des Rechenaufwands kann Gleichung (8) auch umgeformt werden zu

$$\widetilde{p}\left(Y\middle|H_k\right) = \sum_{i=1}^{N} W_{i,k} \cdot \left(Y_i - s_{k,i}\right)^2 , \qquad (9)$$

wobei $W_{i,k}$ die Gewichtungsfaktoren für die jeweiligen Abweichungen darstellen.

In einer alternativen Vereinfachung der Gleichung (8) kann eine Taylor-Reihenentwicklung der Gleichung (8) um einen Offset-Sensorwert $Y_{j0}$ vorgenommen werden, was sich durch die Gleichung

$$\widetilde{p}\left(Y\middle|H_k\right) = \sum_{i=1}^{N}\sum_{j=1}^{N} C_{i,j} \cdot \left(Y_{j0} - s_{k,j}\right) \cdot \left(Y_i - s_{k,i}\right) + p\left(\hat{Y}_0\middle|H_k\right) \qquad (10)$$

ausdrücken lässt. Der letzte Term in Gleichung (10) stellt dabei einen Offset-Wert dar, die aus der Taylor-Reihenentwicklung resultiert. Die Gleichung (10), die durch die Taylor-Reihenentwicklung linearisiert ist, kann umgeordnet auch geschrieben werden als

$$\widetilde{p}\left(Y|H_k\right) = \sum_{i=1}^{N} W_{i,k} \cdot Y_i + C_k \, , \qquad\qquad (11)$$

wobei $W_{i,k}$ wiederum Gewichtsfaktoren darstellen und $C_k$ ein Offsetwert entsprechend der Hypothese $H_k$ ist. Das Durchführen der Vergleichsoperation basiert in diesem Fall auf der Taylor-Reihenentwicklung. Jedoch können auch andere lineare Modelle verwendet werden, die in ausreichender Weise die logarithmierte Likelihood-Funktion beziehungsweise das jeweils verwendete Schätzverfahren annähern können. Beispielsweise kann zur Bestimmung der linearen Approximation ein Monte-Carlo-Ansatz verwendet werden.

Zusätzlich zu den bereits beschriebenen Verfahren zur Bestimmung der Vertrauenswerte beziehungsweise Wahrscheinlichkeiten können auch weitere a-priori-Informationen in den Vertrauenswerten berücksichtigt werden, beispielsweise durch Multiplikation oder Addition weiterer Werte. Beispielsweise ist durch ein weiteres Sensorsignal oder aus einer externen Informationsquelle bekannt, dass eine Position wahrscheinlicher ist als andere. Auch derartige Informationen können durch entsprechende Gewichtsfaktoren beziehungsweise Korrekturfaktoren ausgedrückt werden.

Neben den beschriebenen Vergleichsoperationen zur Bestimmung beziehungsweise zum Auswählen der Position können auch die Größe und/oder der Betrag der Sensorsignale und/oder der Sensorwerte berücksichtigt werden. Beispielsweise steigt ein durchschnittlicher Wert der Sensorsignale beziehungsweise Sensorwerte an, wenn die Magnetquelle in Richtung des Arrays von Magnetfeldsensoren bewegt wird. Dies kann beispielsweise durch Druck auf die Magnetquelle in der angegebenen Richtung erfolgen. Die Erhöhung des durchschnittlichen Betrages der Sensorsignale und/oder der Sensorwerte kann dem entsprechend ausgewertet werden, so dass das Auswählen der Position auch in Abhängigkeit des durchschnittlichen Betrags erfolgt.

Figur 9 zeigt eine beispielhafte Aufteilung von theoretisch möglichen Positionen der Magnetquelle in verschiedene Positionsbereiche, welche jeweils einer der vorbestimmten Positionen entsprechen. Jedem der Positionsbereiche beziehungsweise der Positionen 91 - 99 kann eine jeweilige Hypothese gemäß dem oben beschriebenen Ausführungsbeispiel zugeordnet werden.

Die dargestellte Einteilung ist zusätzlich abhängig von einem jeweiligen Rotationswert, so dass für unterschiedliche Rotationswerte unterschiedliche Einteilungen möglich sind. In diesem Ausführungsbeispiel sind neun Positionen beziehungsweise Positionsbereiche vorgesehen. Mit einem Verfahren gemäß einem der oben beschriebenen Ausführungsbeispiele können jedoch auch Aufteilungen mit mehr oder mit weniger Positionen beziehungsweise Positionsbereichen vorgesehen werden.

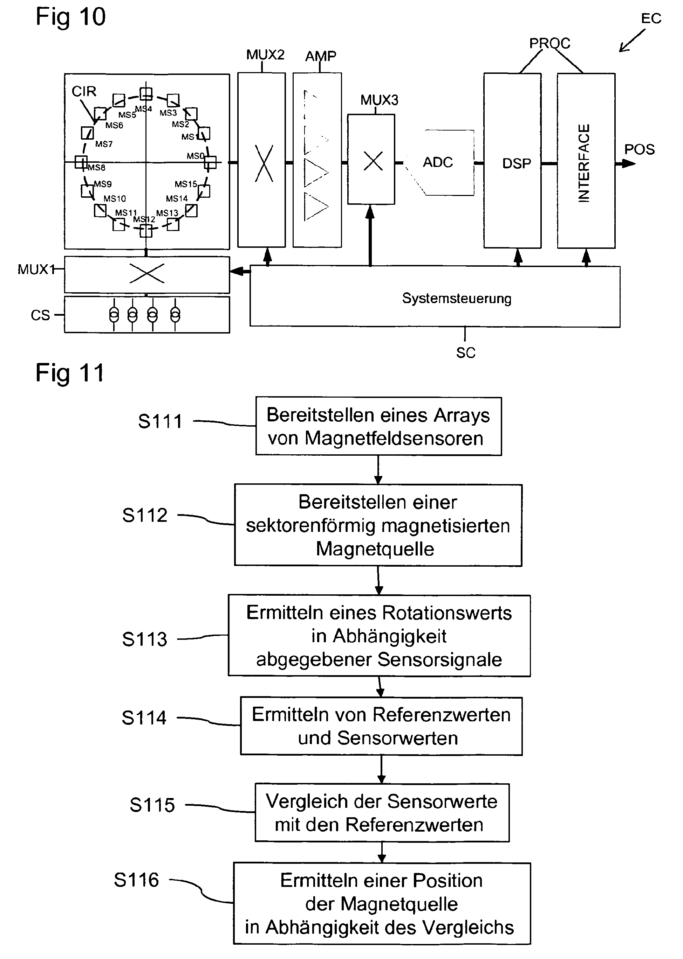

Figur 10 zeigt ein weiteres Ausführungsbeispiel einer Sensoranordnung mit Magnetfeldsensoren MS0 - MS15, die entlang eines kreisförmigen Umfangs CIR angeordnet sind. Die Sensoranordnung weist wiederum eine Auswerteschaltung EC auf, die in diesem Ausführungsbeispiel einen digitalen Signalprozessor DSP und eine Schnittstelle aufweist, die von einer Recheneinheit PROC umfasst sind. Ferner ist eine Stromquelle CS vorgesehen, die über einen ersten Multiplexer MUX1 mit dem Array MS0 - MS15 gekoppelt ist. Ausgangsseitig ist das Array MS0 - MS15 über einen zweiten Multiplexer MUX2, Verstärkungseinrichtungen AMP, einen dritten Multiplexer MUX3 und einen Analog-Digital-Wandler ADC mit der Recheneinheit PROC gekoppelt. Die Sensoranordnung umfasst ferner eine Systemsteuerung SC, welche die Multiplexer MUX1, MUX2, MUX3 und die Recheneinheit PROC steuert.

Die Magnetfeldsensoren MS0 - MS15 sind in diesem Ausführungsbeispiel als Hall-Sensoren ausgeführt, welche mit einem von der Stromquelle CS bereitgestellten Versorgungsstrom betrieben werden. Die Sensorsignale, die von den Magnetfeldsensoren MS0 - MS15 abgegeben werden, werden über die Multiplexer MUX2, MUX3 und die Verstärkungseinrichtung AMP zum Analog-Digital-Wandler ADC geführt, wobei die Sensorsignale einzeln geführt werden können oder durch entsprechende Verschaltung in der Verstärkungseinrichtung AMP auch bereits vor Zuführung an den Analog-Digital-Wandler ADC miteinander kombiniert werden können.

In der Auswerteeinrichtung EC werden die Sensorsignale mit einem Verfahren aus einem der oben beschriebenen Ausführungsbeispiele verarbeitet, so dass die Position einer Magnetquelle, die hier aus Übersichtsgründen nicht dargestellt ist, bestimmt werden kann. Der digitale Signalprozessor DSP kann beispielsweise auch eine Speichereinrichtung aufweisen, in der Koeffizienten zum Herleiten von Sätzen von Referenzwerten sowie zum Bestimmen oder Abrufen von Gewichtsfaktoren abgelegt sind.

Entsprechende Funktionen zum Ermitteln des Rotationswertes der Magnetquelle, zum Ableiten des Satzes von Sensorwerten, zum Ermitteln der Sätze von Referenzwerten, zum Durchführen einer Vergleichsoperation zwischen dem Satz von Sensorwerten und der Anzahl von Sätzen von Referenzwerten und zum Auswählen einer Position aus der Anzahl vorbestimmter Positionen in Abhängigkeit der Vergleichsoperation können in der Auswerteschaltung EC sowohl durch Hardware als auch durch entsprechende Programmierung realisiert sein.

Figur 11 zeigt ein beispielhaftes Ablaufdiagramm eines Verfahrens zum Bestimmen einer Position einer Magnetquelle in Bezug auf ein Array von Magnetfeldsensoren. Die Abfolge der einzelnen beschriebenen Schritte kann auch vertauscht werden. Zusätzlich können einzelne Schritte auch parallel zueinander ausgeführt werden.

Bei S111 wird ein Array von Magnetfeldsensoren bereitgestellt, die beispielsweise als Hall-Sensoren ausgebildet sind. Die Magnetfeldsensoren können jeweils ein Sensorsignal als Spannungssignal oder Stromsignal in Abhängigkeit einer magnetischen Feldintensität abgeben.

Bei S112 wird eine sektorenförmig magnetisierte Magnetquelle bereitgestellt, welche beispielsweise zwei oder mehr magnetische Pole aufweist. Dementsprechend kann die Magnetquelle als diametral magnetisierte Magnetquelle ausgebildet sein. Die Magnetquelle ist beweglich zu dem Array von Magnetfeldsensoren angeordnet und dient zum Erzeugen einer jeweiligen magnetischen Feldintensität, welche von den Magnetfeldsensoren detektiert werden kann.

Bei S113 wird aus den von den Magnetfeldsensoren abgegebenen Sensorsignalen ein Rotationswert der Magnetquelle mit Bezug auf eine Referenzachse des Arrays bestimmt. Die Bestimmung kann beispielsweise über eine Fourier-Analyse oder mittels einer Winkelfunktion aus den Sensorsignalen erfolgen.

Für die weitere Verarbeitung werden bei S114 aus den Sensorsignalen entsprechende Sensorwerte abgeleitet. Ferner werden in Abhängigkeit des zuvor ermittelten Rotationswerts Referenzwerte hergeleitet, die verschiedenen vorbestimmten Positionen der Magnetquelle zugeordnet werden können.

Die abgeleiteten Sensorwerte werden mit den Referenzwerten verglichen, beispielsweise im Rahmen einer Schätzfunktion oder einer Wahrscheinlichkeitsfunktion. Beispielsweise wird für jede der vorbestimmten Positionen durch die Vergleichsoperation ein Wahrscheinlichkeitswert oder Vertrauenswert bestimmt, der angibt, wie wahrscheinlich es ist, dass die Magnetquelle die jeweilige Position eingenommen hat.

In Abhängigkeit des Vergleichs beziehungsweise der ermittelten Wahrscheinlichkeitswerte oder Vertrauenswerte wird bei S116 die Position der Magnetquelle ausgewählt. Beispielsweise wird die Position ausgewählt, welche den höchsten Wahrscheinlichkeitswert aufweist oder bei der die Abweichungen zwischen Referenzwerten und Sensorwerten am geringsten sind.

Mit einem Verfahren gemäß einem der oben beschriebenen Ausführungsbeispiele ist es möglich, eine Position eines Magneten, welche beispielsweise durch Verkippung und/oder Verschiebung bestimmt ist, derart zu bestimmen, dass Einflüsse, die auf einer Rotation der Magnetquelle beruhen, in einfacher Weise berücksichtigt werden können. Zusätzlich ist es möglich, dass die Bestimmung der Position auch bei größeren Toleranzen für verschiedene zu verwendende Magnetquellen ohne Kalibrierung vorgenommen werden kann.

**Patentansprüche**

1. Messverfahren, umfassend

    - Bereitstellen eines Arrays von Magnetfeldsensoren (MSO - MS15), die jeweils ein Sensorsignal in Abhängigkeit einer magnetischen Feldintensität abgeben;
    - Bereitstellen einer sektorenförmig magnetisierten Magnetquelle (MAG), die beweglich zu dem Array (MSO - MS15) angeordnet ist;
    - Ermitteln eines Rotationswerts ($\Phi$) der Magnetquelle (MAG) gegenüber dem Array (MSO - MS15) in Abhängigkeit der abgegebenen Sensorsignale;
    - Ableiten eines Satzes von N Sensorwerten aus den Sensorsignalen;
    - Ermitteln, basierend auf dem zuvor ermittelten Rotationswert ($\Phi$), einer Anzahl K von Sätzen $S_k$ von Referenzwerten $S_{k,i}$, die einer Anzahl K vorbestimmter Positionen der Magnetquelle (MAG) entspricht, wobei jeder der Sätze $S_k$ eine Anzahl N von Referenzwerten umfasst, die der Anzahl N der Sensorwerte entspricht, und wobei der Index i Werte von 1 bis N und der Index k Werte von 1 bis K annehmen kann;
    - Durchführen einer Vergleichsoperation zwischen dem Satz von Sensorwerten und der Anzahl von Sätzen $S_k$ von Referenzwerten; und
    - Auswählen einer Position (POS) aus der Anzahl vorbestimmter Positionen in Abhängigkeit der Vergleichsoperation.

2. Messverfahren nach Anspruch 1,
   bei dem die Sätze von Referenzwerten aus messtechnisch und/oder mittels Feldberechnung ermittelten Feldwerten ermittelt werden.

3. Messverfahren nach Anspruch 1 oder 2,
   bei dem beim Durchführen der Vergleichsoperation Abweichungen zwischen den Sensorwerten des Satzes von Sensorwerten und jeweils zugeordneten Referenzwerten der Sätze von Referenzwerten ermittelt werden.

4. Messverfahren nach Anspruch 3,
   bei dem die Abweichungen mit jeweiligen Gewichtsfaktoren gewichtet werden.

5. Messverfahren nach Anspruch 3 oder 4,
   bei dem aus den ermittelten Abweichungen für jede der vorbestimmten Positionen ein Vertrauenswert abgeleitet wird und die Position (POS) in Abhängigkeit eines Extremwerts der abgeleiteten Vertrauenswerte ausgewählt wird.

6. Messverfahren nach Anspruch 5,
   bei dem beim Ableiten der Vertrauenswerte die Abweichungen für jeden der Sätze von Referenzwerten quadratisch aufsummiert werden.

7. Messverfahren nach Anspruch 5 oder 6,
   bei dem die Vertrauenswerte durch einen Korrekturfaktor in Abhängigkeit zumindest eines der Sensorsignale und/oder Sensorwerte und/oder in Abhängigkeit einer externen Informationsquelle angepasst werden.

8. Messverfahren nach einem der Ansprüche 1 bis 7,
   bei dem das Durchführen der Vergleichsoperation auf einem Detektionsverfahren und/oder einem Wahrscheinlichkeitsverfahren, insbesondere einem Maximum-Likelihood-Verfahren oder einem logarithmierten Likelihood-Verfahren basiert.

9. Messverfahren nach einem der Ansprüche 1 bis 8,
   bei dem das Durchführen der Vergleichsoperation auf einer Taylor-Reihenentwicklung basiert.

10. Messverfahren nach einem der Ansprüche 1 bis 9,
    bei dem beim Ermitteln der Sätze von Referenzwerten und beim Durchführen der Vergleichsoperation Symmetrieeigenschaften des Arrays (MSO - MS15) genutzt werden.

11. Messverfahren nach einem der Ansprüche 1 bis 10,
    bei dem das Auswählen der Position (POS) auch in Abhängigkeit eines durchschnittlichen Betrags der Sensorsignale und/oder der Sensorwerte erfolgt.

12. Sensoranordnung zur Verwendung mit einer sektorenförmig magnetisierten Magnetquelle (MAG), die Sensoranordnung aufweisend ein Array von Magnetfeldsensoren (MSO - MS15), die jeweils eingerichtet sind, ein Sensorsignal in Abhängigkeit einer magnetischen Feldintensität abzugeben, und eine mit dem Array von Magnetfeldsensoren (MSO - MS15) gekoppelte Auswerteeinrichtung (EC), die dazu eingerichtet ist,

    - einen Rotationswert ($\Phi$) in Abhängigkeit der abgegebenen Sensorsignale zu ermitteln;
    - einen Satz von N Sensorwerten aus den Sensorsignalen abzuleiten;
    - basierend auf dem zuvor ermittelten Rotationswert ($\Phi$) eine Anzahl K von Sätzen $S_k$ von Referenzwerten $s_{k,i}$ zu ermitteln, die einer Anzahl K vorbestimmter Positionen einer verwendeten Magnetquelle (MAG) entspricht, wobei jeder der Sätze $S_k$ eine Anzahl N von Referenzwerten umfasst, die der Anzahl N der Sensorwerte entspricht, und wobei der Index i Werte von 1 bis N und der Index k Werte von 1 bis K annehmen kann;
    - eine Vergleichsoperation zwischen dem Satz von Sensorwerten und der Anzahl von Sätzen $S_k$ von Referenzwerten durchzuführen; und
    - eine Position (POS) aus der Anzahl vorbestimmter Positionen in Abhängigkeit der Vergleichsoperation auszuwählen.

13. Sensoranordnung nach Anspruch 12,
    bei der die Auswerteeinrichtung (EC) dazu eingerichtet ist, Abweichungen zwischen den Sensorwerten des Satzes von Sensorwerten und jeweils zugeordneten Referenzwerten der Sätze von Referenzwerten zu ermitteln.

14. Sensoranordnung nach Anspruch 13,
    bei der die Auswerteeinrichtung (EC) dazu eingerichtet ist, aus den ermittelten Abweichungen für jede der vorbestimmten Positionen einen Vertrauenswert abzuleiten und die Position (POS) in Abhängigkeit eines Extremwerts der abgeleiteten Vertrauenswerte auszuwählen.

**15.** Messsystem, umfassend eine Sensoranordnung nach einem der Ansprüche 12 bis 14 und eine sektorenförmig magnetisierte Magnetquelle (MAG), die beweglich zu dem Array (MSO - MS15) der Sensoranordnung angeordnet ist.

**Claims**

**1.** A measuring method, comprising

- providing an array of magnetic field sensors (MSO - MS15) each delivering a sensor signal depending on a magnetic field intensity;
- providing a magnet source (MAG) magnetized in sector shape and arranged so as to be movable relative to the array (MSO - MS15);
- determining a rotation value ($\Phi$) of the magnet source (MAG) with respect to the array (MSO - MS15) depending on the delivered sensor signals;
- deriving a set of N sensor values from the sensor signals;
- determining a number K of sets $S_k$ of reference values $S_{k,i}$ based on the previously determined rotation value ($\Phi$), which corresponds to a number K of predetermined positions of the magnet source (MAG), each of the sets $S_k$ comprising a number N of reference values which corresponds to the number N of the sensor values, and where index i may assume values from 1 to N and index k may assume values from 1 to K;
- carrying out a comparison operation between the set of sensor values and the number of sets $S_k$ of reference values; and
- selecting a position (POS) from the number of predetermined positions depending on the comparison operation.

**2.** The measuring method according to claim 1, wherein the sets of reference values are determined from field values which have been determined by measurement engineering and/or by means of field computation.

**3.** The measuring method according to claim 1 or 2, wherein deviations between the sensor values of the set of sensor values and respectively associated reference values of the sets of reference values are determined during carrying out the comparison operation.

**4.** The measuring method according to claim 3, wherein the deviations are weighted with respective weighting factors.

**5.** The measuring method according to claim 3 or 4, wherein a confidence value is derived from the determined deviations for each of the predetermined positions and the position (POS) is selected depending on an extreme value of the derived confidence values.

**6.** The measuring method according to claim 5, wherein the deviations for each of the sets of reference values are squared and summed up during the derivation of the confidence values.

**7.** The measuring method according to claim 5 or 6, wherein the confidence values are adapted by a correction factor depending on at least one of the sensor signals and/or sensor values and/or depending on an external information source.

**8.** The measuring method according to any of claims 1 to 7, wherein carrying out the comparison operation is based on a detection method and/or a likelihood method, in particular a maximum likelihood method or a logarithm-based likelihood method.

**9.** The measuring method according to any of claims 1 to 8, wherein carrying out the comparison operation is based on a Taylor series expansion.

**10.** The measuring method according to any of claims 1 to 9, wherein symmetry properties of the array (MSO - MS15) are used in determining the sets of reference values and carrying out the comparison operation.

**11.** The measuring method according to any of claims 1 to 10,

wherein selecting the position (POS) is also carried out depending on an average amount of the sensor signals and/or of the sensor values.

**12.** A sensor arrangement for use with a magnet source (MAG) magnetized in sector shape, the sensor arrangement comprising an array of magnetic field sensors (MSO - MS15) each arranged to deliver a sensor signal depending on a magnetic field intensity, and an evaluation device (EC) which is coupled to the array of magnetic field sensors (MSO - MS15) and is arranged to

- determine a rotation value ($\Phi$) depending on the delivered sensor signals;
- derive a set of N sensor values from the sensor signals;
- determine a number K of sets $S_k$ of reference values $S_{k,i}$ based on the previously determined rotation value ($\Phi$), which corresponds to a number K of predetermined positions of a magnet source (MAG) used, each of the sets $S_k$ comprising a number N of reference values which corresponds to the number N of the sensor values, and where index i may assume values from 1 to N and index k may assume values from 1 to K;
- carry out a comparison operation between the set of sensor values and the number of sets $S_k$ of reference values; and
- select a position (POS) from the number of predetermined positions depending on the comparison operation.

**13.** The sensor arrangement according to claim 12, wherein the evaluation device (EC) is arranged to determine deviations between the sensor values of the set of sensor values and respectively associated reference values of the sets of reference values.

**14.** The sensor arrangement according to claim 13, wherein the evaluation device (EC) is arranged to derive a confidence value from the determined deviations for each of the predetermined positions and to select the position (POS) depending on an extreme value of the derived confidence values.

**15.** A measuring system comprising a sensor arrangement according to any of claims 12 to 14 as well as a magnet source (MAG) magnetized in sector shape and arranged so as to be movable relative to the array (MSO - MS15) of the sensor arrangement.

**Revendications**

**1.** Procédé de mesure, comportant

- la mise à disposition d'une rangée de capteurs de champ magnétique (MSO - MS15) délivrant chacun un signal de capteur en fonction d'une intensité de champ magnétique ;
- la mise à disposition d'une source magnétique (MAG) magnétisée en forme de secteur et disposée de manière mobile par rapport à la rangée (MSO - MS15) ;
- la détermination d'une valeur de rotation ($\Phi$) de la source magnétique (MAG) par rapport à la rangée (MSO - MS15) en fonction des signaux de capteur délivrés ;
- la déduction d'un jeu de N valeurs de capteur à partir des signaux de capteur ;
- la détermination, sur la base de la valeur de rotation ($\Phi$) préalablement déterminée, d'un nombre K de jeux $S_k$ de valeurs de référence $S_{k,i}$ correspondant à un nombre K de positions prédéterminées de la source magnétique (MAG), chacun des jeux $S_k$ comportant un nombre N de valeurs de référence correspondant au nombre N de valeurs de capteur, et l'indice i pouvant prendre des valeurs de 1 à N et l'indice k des valeurs de 1 à K ;
- l'exécution d'une opération de comparaison entre le jeu de valeurs de capteur et le nombre de jeux $S_k$ de valeurs de référence ; et
- la sélection d'une position (POS) parmi le nombre de positions prédéterminées en fonction de l'opération de comparaison.

**2.** Procédé de mesure selon la revendication 1, où les jeux de valeurs de référence sont déterminés à partir de valeurs de champ déterminées par technique de mesure et/ou par calcul de champ.

**3.** Procédé de mesure selon la revendication 1 ou 2, où des écarts entre les valeurs de capteur du jeu de valeurs de capteur et des valeurs de référence respectivement assignées des jeux de valeurs de référence sont déterminés lors de l'exécution de l'opération de comparaison.

4. Procédé de mesure selon la revendication 3,
où les écarts sont pondérés avec des facteurs de pondération respectifs.

5. Procédé de mesure selon la revendication 3 ou 4,
où une valeur de confiance est déduite à partir des écarts déterminés pour chacune des positions prédéterminées et la position (POS) est sélectionnée en fonction d'une valeur extrême des valeurs de confiance déduites.

6. Procédé de mesure selon la revendication 5,
où, lors de la déduction des valeurs de confiance, les écarts sont additionnés au carré pour chacun des jeux de valeurs de référence.

7. Procédé de mesure selon la revendication 5 ou 6,
où les valeurs de confiance sont adaptées moyennant un facteur de correction en fonction d'au moins un des signaux de capteur et/ou des valeurs de capteur et/ou en fonction d'une source d'information externe.

8. Procédé de mesure selon l'une des revendications 1 à 7,
où l'exécution de l'opération de comparaison est basée sur un procédé de détection et/ou un procédé de probabilité, en particulier un procédé de maximum de vraisemblance ou un procédé de vraisemblance par logarithme.

9. Procédé de mesure selon l'une des revendications 1 à 8,
où l'exécution de l'opération de comparaison est basée sur un développement en série de Taylor.

10. Procédé de mesure selon l'une des revendications 1 à 9,
où des propriétés de symétrie de la rangée (MSO - MS15) sont utilisées lors de la détermination des jeux de valeurs de référence et lors de l'exécution de l'opération de comparaison.

11. Procédé de mesure selon l'une des revendications 1 à 10,
où la sélection de la position (POS) est également effectuée en fonction d'une valeur moyenne des signaux de capteur et/ou des valeurs de capteur.

12. Ensemble de capteurs destiné à être utilisé avec une source magnétique (MAG) magnétisée en forme de secteur, l'ensemble de capteurs présentant une rangée de capteurs de champ magnétique (MSO - MS15) respectivement configurés pour délivrer un signal de capteur en fonction d'une intensité de champ magnétique, et un dispositif d'évaluation (EC) couplé à la rangée de capteurs de champ magnétique (MSO - MS15) et configuré pour

- déterminer une valeur de rotation ($\Phi$) en fonction des signaux de capteur délivrés ;
- déduire un jeu de N valeurs de capteur à partir des signaux de capteur ;
- déterminer, sur la base de la valeur de rotation ($\Phi$) préalablement déterminée, un nombre K de jeux $S_k$ de valeurs de référence $S_{k,i}$ correspondant à un nombre K de positions prédéterminées d'une source magnétique (MAG) employée, chacun des jeux $S_k$ comportant un nombre N de valeurs de référence correspondant au nombre N de valeurs de capteur, et l'indice i pouvant prendre des valeurs de 1 à N et l'indice k des valeurs de 1 à K ;
- effectuer une opération de comparaison entre le jeu de valeurs de capteur et le nombre de jeux $S_k$ de valeurs de référence ; et
- sélectionner une position (POS) parmi le nombre de positions prédéterminées en fonction de l'opération de comparaison.

13. Ensemble de capteurs selon la revendication 12,
où le dispositif d'évaluation (EC) est configuré pour déterminer des écarts entre les valeurs de capteur du jeu de valeurs de capteur et des valeurs de référence respectivement assignées des jeux de valeurs de référence.

14. Ensemble de capteurs selon la revendication 13,
où le dispositif d'évaluation (EC) est configuré pour déduire une valeur de confiance à partir des écarts déterminés pour chacune des positions prédéterminées et sélectionner la position (POS) en fonction d'une valeur extrême des valeurs de confiance déduites.

15. Système de mesure, comportant un ensemble de capteurs selon l'une des revendications 12 à 14 et une source magnétique (MAG) magnétisée en forme de secteur et disposée de manière mobile par rapport à la rangée (MSO - MS15) de l'ensemble de capteurs.

Fig 1

Fig 2

Fig 3

Fig 4

Fig 5

Fig 6

Fig 7

Fig 8

Fig 9

EP 2 165 158 B1

Fig 10

CIR
MS5 MS4 MS3
MS6 MS2
MS7 MS1
MS8 MS0
MS9 MS15
MS10 MS14
MS11 MS13
MS12

MUX2  AMP  MUX3

MUX1

CS

ADC  DSP  INTERFACE  POS

PROC  EC

Systemsteuerung

SC

Fig 11

S111 — Bereitstellen eines Arrays von Magnetfeldsensoren

S112 — Bereitstellen einer sektorenförmig magnetisierten Magnetquelle

S113 — Ermitteln eines Rotationswerts in Abhängigkeit abgegebener Sensorsignale

S114 — Ermitteln von Referenzwerten und Sensorwerten

S115 — Vergleich der Sensorwerte mit den Referenzwerten

S116 — Ermitteln einer Position der Magnetquelle in Abhängigkeit des Vergleichs

20

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0621493 A1
- WO 0023824 A
- US 5959863 A
- US 2002077752 A